# EUROPÄISCHE PATENTANMELDUNG

(11) **EP 2 330 647 A1**
(43) Veröffentlichungstag der Anmeldung: **08.06.2011**
(21) Anmeldenummer: 10191756.5
(22) Anmeldetag: 18.11.2010
(51) Int. Cl.: H01L 41/053, H01L 41/083, B60J 1/17

(54) **Vielschichtaktor**

(30) Priorität: 04.12.2009 DE 102009047551
(71) Anmelder: Robert Bosch GmbH, 70442 Stuttgart (DE)
(72) Erfinder: Deromelaere, Gaetan, 70806, Kornwestheim (DE); Spremo, Ivan, 70197, Stuttgart (DE)

(57) **Zusammenfassung**

Die Erfindung betrifft einen Vielschichtaktor (15), mit aus bezüglich ihrer elektrischen Polarität alternierend angeordneten Piezoelementen (16), die einen Stapel ausbilden, wobei die Piezoelemente (16) jeweils ringförmig ausgebildet sind und in ihrer Längsachse mit einer Schraube (21) und einem mit der Schraube (21) zusammenwirkenden Gegenelement axial vorgespannt sind. Erfindungsgemäß ist es vorgesehen, dass der Kopf (23) der Schraube (21) als erstes Gegenlager für das dem Kopf (23) der Schraube (21) zugewandten Piezoelement (16) dient und, dass die Schraube (21) mit einem Schraubenabschnitt (25) aus dem Stapel herausragt und mit einem Gewinde (22) in einem Trägerelement (11) als zweitem Gegenlager zusammenwirkt.

## Beschreibung

### Stand der Technik

Die Erfindung betrifft einen Vielschichtaktor nach dem Oberbegriff des Anspruchs 1.

Ein derartiger Vielschichtaktor ist aus der DE 10 2007 021 337 A1 bekannt. Hierbei ist der bekannte Vielschichtaktor Bestandteil eines Verstellantriebes, wie er z.B. in einem Fensterheberantrieb eines Kraftfahrzeuges verwendet wird. Der vorbekannte Vielschichtaktor besteht hierbei gemäß Fig. 8a der DE 10 2007 021 337 A1 aus übereinander gestapelten, ringförmigen Piezoelementen, welche mittels eines Fußteils und eines Kopfteiles unter Verwendung einer Spannschraube miteinander verbunden sind. Dies bedeutet, dass der bekannte Vielschichtaktor aus einer relativ großen Anzahl von Einzelbauteilen zusammengesetzt ist.

### Offenbarung der Erfindung

Ausgehend von dem dargestellten Stand der Technik liegt der Erfindung die Aufgabe zugrunde, einen Vielschichtaktor nach dem Oberbegriff des Anspruchs 1 derart weiterzubilden, dass dieser besonders kostengünstig herstellbar ist. Diese Aufgabe wird bei einem Vielschichtaktor mit den Merkmalen des Anspruchs 1 gelöst. Der Erfindung liegt dabei die Idee zugrunde, eine Schraube zu verwenden, deren Schraubenkopf als Kopfteil verwendet wird, während der aus dem Stapel herausragende Gewindeabschnitt der Schraube direkt mit einem Trägerelement zusammenwirkt. Mit anderen Worten gesagt bedeutet dies, dass auf ein Fußteil, wie dies bei dem Vielschichtaktor gemäß dem Stand der Technik bekannt ist, bei der Erfindung verzichtet wird und das Trägerelement die Funktion des Fußteils übernimmt.

Vorteilhafte Weiterbildungen des erfindungsgemäßen Vielschichtaktors sind in den Unteransprüchen angegeben. In den Rahmen der Erfindung fallen sämtliche Kombination aus zumindest zwei von in den Ansprüchen, der Beschreibung und/oder den Figuren offenbarten Merkmalen.

Da die Montage der Piezoelemente bzw. des Vielschichtaktors in Zusammenhang mit der Montage an dem Trägerelement steht, ist es besonders vorteilhaft, wenn die Piezoelemente elektrische Anschlüsse aufweisen, wobei die elektrischen Anschlüsse sowie die die elektrischen Anschlüsse verbindenden Leitungen an dem Außenumfang der Piezoelemente angeordnet sind. Dies ist deshalb vorteilhaft, da somit eventuelle Beschädigungen in Folge des Montageprozesses des Vielschichtaktors an dem Trägerelement vermieden werden können.

In einer konstruktiv vorteilhaften Ausgestaltung der Erfindung ist es dabei vorgesehen, dass das Trägerelement Bestandteil eines Verstellantriebs ist. Insbesondere kann es dabei vorgesehen sein, dass das Trägerelement eine Brücke ist, an der zwei Vielschichtaktoren angeordnet sind und, dass auf der den Vielschichtaktoren gegenüberliegenden Seite der Brücke ein Stößelelement angeordnet ist, das mit einem zu verstellenden Element zumindest mittelbar zusammenwirkt. Bei dem Element kann es sich hierbei z.B. um ein Fenster eines Kraftfahrzeuges handeln.

Besonders vorteilhaft ist, dass die Erfindung es ermöglicht, dass die Schraube als Standardschraube ausgebildet ist. Unter einer Standardschraube wird hierbei eine handelsübliche, nach DIN- bzw. ISO spezifizierte Schraube verstanden. Es müssen somit keine speziell hergestellten Schrauben verwendet werden, vielmehr lassen sich die Piezoelemente bzw. deren Größe an die Bemaßung von Standardschrauben anpassen.

Um eine gleichmäßige Einleitung der axialen Spannkraft in das dem Schraubenkopf zugewandte Piezoelement zu ermöglichen, ist es darüber hinaus vorteilhaft, wenn die Schraube in der Zwischenlage eine Unterlegscheibe mit dem ihr zugewandten Piezoelement zusammenwirkt.

Die Erfindung umfasst auch einen Verstellantrieb unter Verwendung wenigstens eines erfindungsgemäßen Vielschichtaktors. Aufgrund der preiswerten Herstellbarkeit der Vielschichtaktoren ist somit auch der Verstellantrieb insgesamt gesehen relativ preiswert realisierbar.

Weitere Vorteile des erfindungsgemäßen Vielschichtaktors ergeben sich aus der nachfolgenden Beschreibung bevorzugter Ausführungsbeispiele sowie anhand der Zeichnungen.

Diese zeigen in:
- Fig. 1: eine vereinfachte Seitenansicht auf einen Verstellantrieb für eine Kraftfahrzeugkomponente und
- Fig. 2: eine teilweise geschnittene Seitenansicht auf den Verstellantrieb gemäß der Fig. 1 in einem Teilbereich des Verstellantriebs.

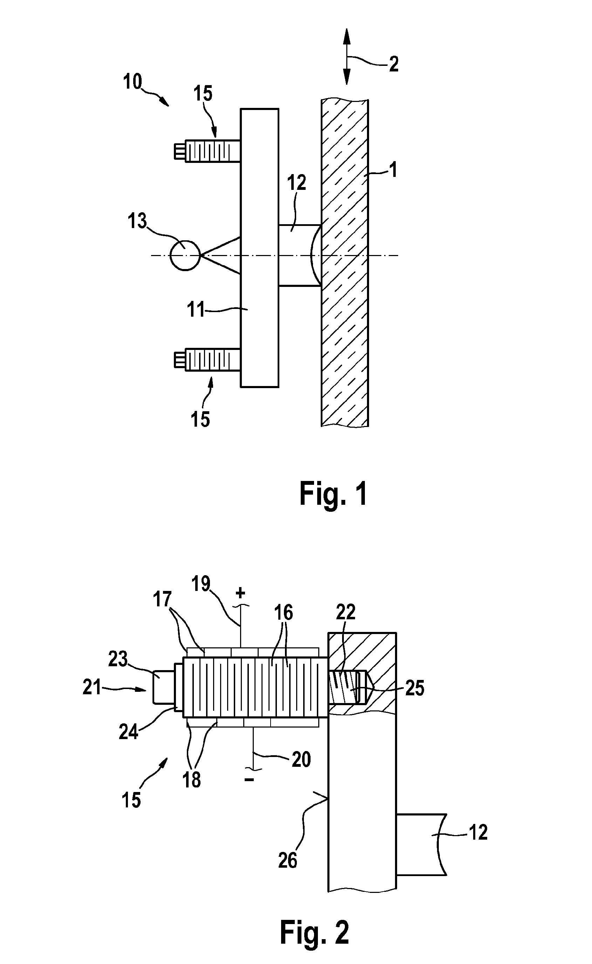

In der Fig. 1 ist ein Verstellantrieb 10 dargestellt, wie er insbesondere in einem Kraftfahrzeug verwendet wird. Hierbei dient der Verstellantrieb 10 zur Verstellung eines Elementes 1 in Richtung des Doppelpfeils 2. Bei dem Element 1 kann es sich beispielsweise um eine Scheibe eines Kraftfahrzeugs oder ähnliches handeln, welches mittels des Verstellantriebs 10 angehoben bzw. abgesenkt wird.

In den Rahmen der Erfindung fallen jedoch auch sämtliche andere Verstellantriebe, wie sie insbesondere für die Betätigung von Komfortantrieben in Kraftfahrzeugen dienen.

Der Verstellantrieb 10 weist im Wesentlichen einen länglichen Träger in Form einer Brücke 11 auf, der auf der dem Element 1 zugewandten Seite mittig ein Stößelelement 12 trägt. Das Stößelelement 12 dient der Übertragung einer in Richtung des Doppelpfeils 2 wirkenden Kraftkomponente auf das Element 1. Die Brücke 11 ist fluchtend zum Stößelelement 12 in einem Lagerelement 13 gelagert. Das Lagerelement 13 ist wiederum bevorzugt mit einem feststehenden Teil des Kraftfahrzeugs verbunden. Der grundsätzliche Aufbau und die Funktionsweise eines derartigen Verstellantriebs wird darüber hinaus beispielhaft auch in der DE 10 2007 021 337 A1 der Anmelderin näher beschrieben, auf die somit Bezug genommen wird.

Auf der Brücke 11 sind auf der dem Stößelelement 12 gegenüberliegenden Seite in gleichem Abstand zum Stößelelement 12 bzw. zum Lagerelement 13 je ein erfindungsgemäßer Vielschichtaktor 15 angeordnet. Wie insbesondere aus der Fig. 2 erkennbar ist, besteht jeder der Vielschichtaktoren 15 aus einer Vielzahl von übereinander gestapelten, ringförmig ausgebildeten Piezoelementen 16, die insgesamt gesehen einen Stapel bilden. Die Piezoelemente 16 sind hierbei bezüglich ihrer Polarität alternierend übereinander angeordnet, und tragen an ihrer Außenfläche elektrische Anschlüsse 17 bzw. 18, die über Leitungen 19, 20 mit einer nicht dargestellten Stromquelle zur Ansteuerung der Vielschichtaktoren 15 versehen sind.

Erfindungsgemäß ist es vorgesehen, dass zur Ausbildung der Vielschichtaktoren 15 eine handelsübliche Schraube 21 verwendet wird, welche die mittigen, kreisförmigen Durchbrüche der Piezoelemente 16 in deren Längsachse durchdringt und in einem in der Brücke 11 ausgebildeten Gewinde 22 einschraubbar ist. Hierbei ist der Kopf 23 der Schraube 21 unter Verwendung einer Unterlegscheibe 24 in Wirkverbindung mit dem dem Kopf 23 der Schraube 21 zugewandten Piezoelement 16 angeordnet.

Die Schraube 21 dient dazu, die übereinander gestapelten Piezoelemente 16 mit einer Axialkraft zu beaufschlagen bzw. diese vorzuspannen. Hierzu wirkt über den Kopf 23 bzw. die Unterlegscheibe 24 eine Axialkraft senkrecht zur Brücke 11, welche über das Gewinde 22 den aus den Piezoelementen 16 herausragenden Schraubenabschnitt 25 aufnimmt und mit seiner dem Vielschichtaktor 15 zugewandten Seite 26 ein Gegenlager bildet, damit die Axialkraft der Schraube 21 auf die Piezoelemente 16 übertragen werden kann.

Der soweit beschriebene Vielschichtaktor 15 kann in vielfältiger Art und Weise modifiziert bzw. abgewandelt werden. So ist es beispielsweise denkbar, die elektrischen Anschlüsse 17 und 18 nicht an der Außenfläche der Piezoelemente 16 vorzusehen, sondern an der ringförmigen Innenfläche der Piezoelemente 16. Weiterhin ist es auch denkbar, anstelle ringförmiger Piezoelemente 16 einen monolithisch aufgebauten Vielschichtaktor auszubilden. Hierbei durchgreift dann die Schraube 21 eine entsprechende Bohrung in dem monolithischen Piezoaktor.

## Patentansprüche

1. Vielschichtaktor (15), mit aus bezüglich ihrer elektrischen Polarität alternierend angeordneten Piezoelementen (16), die einen Stapel ausbilden, wobei die Piezoelemente (16) jeweils ringförmig ausgebildet sind und in ihrer Längsachse mit einer Schraube (21) und einem mit der Schraube (21) zusammenwirkenden Gegenelement axial vorgespannt sind,
**dadurch gekennzeichnet,**
**dass** der Kopf (23) der Schraube (21) als erstes Gegenlager für das dem Kopf (23) der Schraube (21) zugewandten Piezoelement (16) dient und, dass die Schraube (21) mit einem Schraubenabschnitt (25) aus dem Stapel herausragt und mit einem Gewinde (22) in einem Trägerelement (11) als zweitem Gegenlager zusammenwirkt.

2. Vielschichtaktor nach Anspruch 1,
**dadurch gekennzeichnet,**
**dass** die Piezoelemente (16) elektrische Anschlüsse (17, 18) aufweisen und, dass die elektrischen Anschlüsse (17, 18) sowie die elektrischen Anschlüsse (17, 18) verbindende Leitungen (19, 20) am Außenumfang der Piezoelemente (16) angeordnet sind.

3. Vielschichtaktor nach Anspruch 1 oder 2,
**dadurch gekennzeichnet,**
**dass** das Trägerelement (11) Bestandteil eines Verstellantriebs (10) ist.

4. Vielschichtaktor nach Anspruch 3,
**dadurch gekennzeichnet,**
**dass** das Trägerelement eine Brücke (11) ist, an der zwei Vielschichtaktoren (15) angeordnet sind und, dass auf der den Vielschichtaktoren (15) gegenüberliegenden Seite der Brücke (11) ein Stößelelement (12) angeordnet ist, das mit einem zu verstellenden Element (1) zumindest mittelbar zusammenwirkt.

5. Vielschichtaktor nach einem der Ansprüche 1 bis 4,
**dadurch gekennzeichnet,**
**dass** die Schraube (21) als Standardschraube ausgebildet ist.

6. Vielschichtaktor nach einem der Ansprüche 1 bis 5,
**dadurch gekennzeichnet,**
**dass** die Schraube (21) unter Zwischenlage einer Unterlegscheibe (24) mit dem ihr zugewandten Piezoelement (16) zusammenwirkt.

7. Verwendung eines Vielschichtaktuators (15) nach einem der vorhergehenden Ansprüche in einem Kraftfahrzeug-Verstellantrieb, insbesondere in einem Fensterheberantrieb.

8. Verstellantrieb (10), vorzugsweise für eine verstellbare Kraftfahrzeugkomponente, mit wenigstens einem Vielschichtaktor (15) nach einem der Ansprüche 1 bis 7.
